Europäisches Patentamt

(19) European Patent Office

Office européen des brevets

(11) Numéro de publication : **0 165 861**
**B1**

(12) **FASCICULE DE BREVET EUROPÉEN**

(45) Date de publication du fascicule du brevet :
17.08.88

(51) Int. Cl.⁴ : **H 05 K 9/00, H 01 R 9/05**

(21) Numéro de dépôt : 85401153.3

(22) Date de dépôt : 12.06.85

(54) **Dispositif de blindage électromagnétique de câblage électrique constitué de faisceaux de câbles comportant des dérivations.**

(30) Priorité : 14.06.84 FR 8409285

(43) Date de publication de la demande :
27.12.85 Bulletin 85/52

(45) Mention de la délivrance du brevet :
17.08.88 Bulletin 88/33

(84) Etats contractants désignés :
BE DE FR GB IT NL

(56) Documents cités :
AU-B- 2 994 367
DE-A- 2 823 949
US-A- 3 336 056
NAVY TECHNICAL DISCLOSURE BULLETIN, vol. 5,
no. 6, juin 1980, pages 9-11, Arlington, US; J.E.
ACORD: "Connector for electro-magnetic shielding"

(73) Titulaire : SOCIETE NATIONALE D'ETUDE ET DE
CONSTRUCTION DE MOTEURS D'AVIATION,
"S.N.E.C.M.A."
2 Boulevard Victor
F-75015 Paris (FR)

(72) Inventeur : Batt, André
19, rue du Lac aux Belles
F-78320 Le Mesnil Saint Denis (FR)
Inventeur : Delabie, Jacques Joseph Alcide
4, avenue Michel Goutier
F-94380 Bonneuil Sur Marne (FR)

(74) Mandataire : Moinat, François
S.N.E.C.M.A. Service des Brevets Boîte Postale 81
F-91003 Evry Cédex (FR)

## Description

L'invention concerne un dispositif de blindage électromagnétique de câblage électrique constitué de faisceaux de câbles comportant des dérivations, selon le préambule de la revendication 1.

De nombreuses installations électriques ou électroniques comportent des faisceaux de câbles qui doivent être protégés de rayonnements électromagnétiques perturbateurs. A cet effet, ces faisceaux de câbles comportent une gaine extérieure, constituée généralement d'une tresse métallique formant une cage de Faraday, dite de blindage haute fréquence. Lorsque de tels faisceaux comportent des dérivations, il importe qu'il ne se produise pas de faille dudit blindage au niveau de la jonction de la dérivation avec le faisceau principal. Ce problème se pose avec une acuité particulière chaque fois qu'il importe que les différents signaux de faibles niveaux utilisés ne subissent aucune perturbation due à des rayonnements électromagnétiques de spectre très variés et d'origines très diverses. De la même façon, ces faisceaux de câbles peuvent véhiculer des tensions susceptibles d'être une source de perturbations dont il importe de préserver leur environnement.

En conséquence, les impératifs en la matière sont de plus en plus sévères et dans de nombreux cas il est nécessaire de minimiser la présence de failles dans le blindage des faisceaux de câbles, notamment aux jonctions des dérivations. Un tel impératif était rarement satisfait dans l'art antérieur où il était notamment habituel de réunir électriquement entre elles les gaines métalliques du câble principal et de la dérivation, tout en faisant une sorte d'enrobage de la jonction proprement dite. On a aussi pensé à réaliser des gaines métalliques tressées de manière complexe pour épouser parfaitement la dérivation, mais cette solution est très coûteuse et peu souple d'emploi. De plus, ces dispositions présentent l'inconvénient d'une assez grande fragilité mécanique d'où la création possible d'ouvertures dans le blindage. De petites ouvertures peuvent rapidement être la cause de perturbations importantes sous l'action de champs électromagnétiques de fréquences élevées.

La présente invention a précisément pour objet un dispositif de blindage électromagnétique de câblage électrique constitué de faisceaux de câbles comportant des dérivations, du genre dans lequel chaque faisceau de câbles principal et chaque faisceau de câbles dérivé sont enfermés dans une gaine constituée d'une tresse métallique de blindage, caractérisé en ce que, chaque dérivation est entourée d'une bague métallique extérieurement recouverte par la gaine métallique de blindage de ladite dérivation et en ce que les différentes bagues métalliques des différentes dérivations en un point du câblage sont juxtaposées et l'ensemble ainsi formé est recouvert extérieurement successivement par la gaine de blindage du faisceau de câbles principal et par une bague métallique externe qui assure le serrage de l'ensemble.

Suivant une forme de réalisation préférée, chaque bague métallique qui entoure une dérivation est placée autour de la gaine métallique de blindage de ladite dérivation et est recouverte extérieurement par un retour de ladite gaine.

Avantageusement, les bagues métalliques qui entourent les dérivations ont des profils complémentaires qui reconstituent, après juxtaposition, un profil externe semblable à celui du câble principal et la solidarisation de l'ensemble est assurée par sertissage de la bague métallique externe ou pour tout autre moyen de serrage.

En se référant aux figures schématiques ci-jointes, on va décrire des exemples de mise en œuvre de l'invention donnés à titre non limitatif.

La figure 1 représente, en coupe longitudinale, un dispositif de blindage électromagnétique conforme à l'invention.

La figure 2 représente, en coupe longitudinale, un dispositif de blindage électromagnétique conforme à l'invention, dans une forme de réalisation préférée.

La figure 3 représente, en coupe transversale, des bagues métalliques utilisées pour la mise en œuvre de l'invention.

La figure 4 représente, également en coupe transversale, une deuxième forme de bagues métalliques.

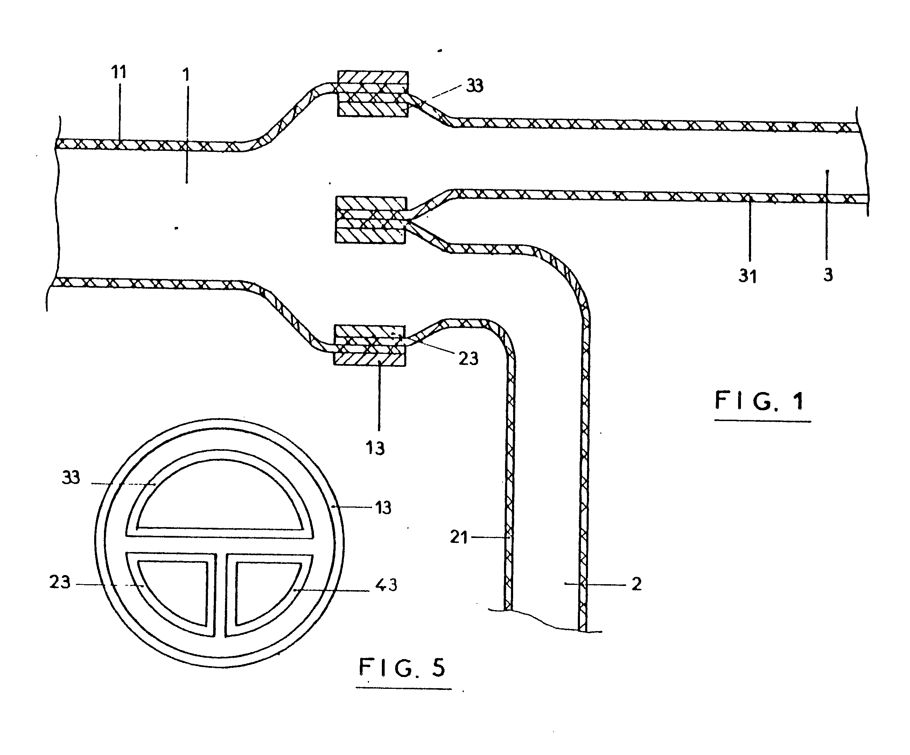

A titre d'exemple, on a représenté à la figure 1 un faisceau principal 1 de câbles électriques qui se divise en deux faisceaux secondaires 2 et 3. Chaque faisceau de câbles se compose, de l'intérieur vers l'extérieur, des câbles proprement dits, non représentés sur la figure et d'une tresse métallique de blindage, respectivement 11, 21 et 31. Le dispositif de la présente invention a précisément pour objet d'assurer une continuité parfaite du blindage électromagnétique obtenu par les gaines 11, 21 et 31. A cet effet, le faisceau 2 de câbles est entouré d'une bague métallique 23 dont la section interne correspond à la section externe dudit faisceau 2 et qui est extérieurement recouverte par la gaine 21. Il en est de même pour le faisceau 3 sur lequel est placé une bague métallique 33 recouverte extérieurement par la gaine métallique 31.

Les bagues 23 et 33 sont juxtaposées et l'ensemble ainsi formé est recouvert extérieurement successivement par la gaine métallique 11 de blindage du faisceau 1 et par une bague métallique 13 chargée d'assurer le serrage de l'ensemble, de préférence par sertissage.

La figure 5 représente, également en coupe transversale, une troisième forme de bagues métalliques.

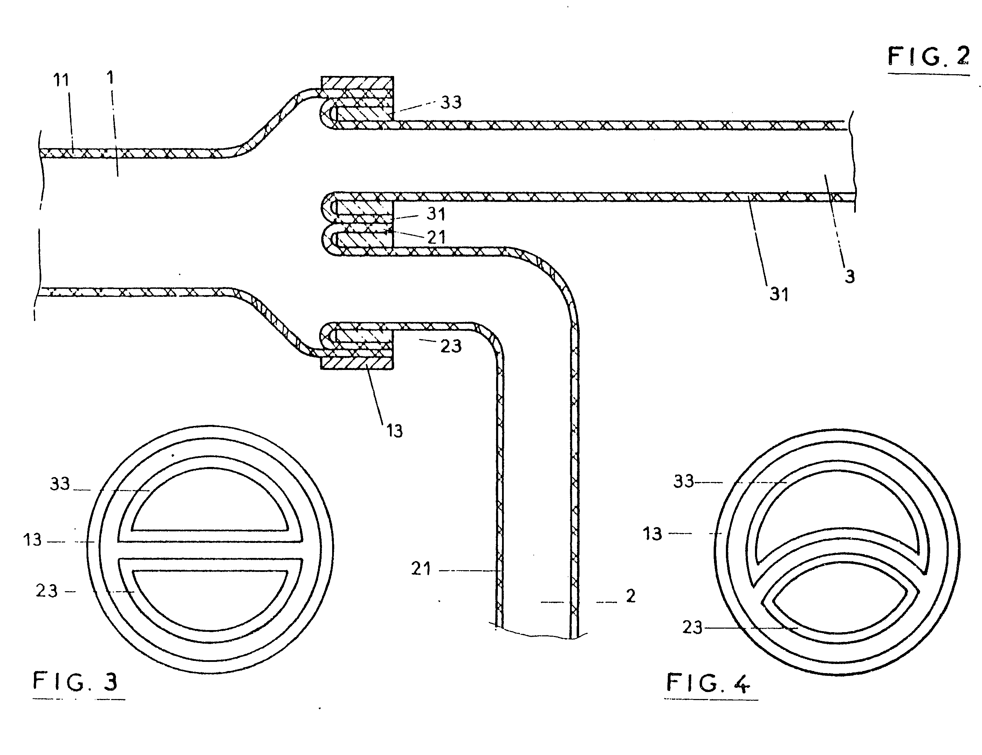

Dans la forme de réalisation préférée illustrée par la figure 2, la bague métallique 23 est recouverte extérieurement par un retour de la gaine métallique 21. De même, la bague métallique 33 est recouverte extérieurement par un retour de la gaine métallique 31. Cette disposition, qui conduit à un encombrement diamétral légèrement supérieur à celui de la précédente, présente des qualités mécaniques, notamment à la traction, accrues.

Comme le montrent les trois exemples représentés par les figures 3, 4 et 5, les bagues métalliques 23, 33 et 43, ont avantageusement des profils complémentaires qui reconstituent, après juxtaposition, un profil externe semblable à celui du faisceau principal. Les formes à adopter pour ces bagues dépendent des sections et des orientations des faisceaux.

En plus d'excellentes propriétés de blindage électromagnétique, le dispositif de l'invention possède une bonne tenue mécanique à la traction, avec un encombrement réduit. De plus, cette disposition autorise des déplacements relatifs de câbles dans les faisceaux, donc permet la réparabilité des faisceaux électriques.

**Revendications**

1. Dispositif de blindage électromagnétique de câblage électrique constitué de faisceaux de câbles comportant des dérivations, du genre dans lequel chaque faisceau de câbles principal (1) et chaque faisceau de câbles dérivé (2, 3) sont enfermés dans une gaine constituée d'une tresse métallique de blindage, caractérisé en ce que chaque dérivation (2, 3) est entourée d'une bague métallique (23, 33) extérieurement recouverte par la gaine métallique de blindage (21, 31) de ladite dérivation et en ce que les différentes bagues métalliques (23, 33) des différentes dérivations en un point du câblage sont juxtaposées et l'ensemble ainsi formé est recouvert extérieurement successivement par la gaine de blindage (11) du faisceau de câbles principal (1) et par une bague métallique (13) externe qui assure le serrage de l'ensemble.

2. Dispositif de blindage électromagnétique suivant la revendication 1, caractérisé en ce que chaque bague métallique (23, 33) qui entoure une dérivation est placée autour de la gaine métallique (21, 31) de blindage de ladite dérivation et est recouverte extérieurement par un retour de ladite gaine.

3. Dispositif de blindage électromagnétique suivant l'une des revendications précédentes, caractérisé en ce que les bagues métalliques qui entourent les dérivations ont des profils complémentaires qui reconstituent, après juxtaposition, un profil externe semblable à celui du câble principal.

4. Dispositif de blindage électromagnétique suivant l'une des revendications précédentes, caractérisé en ce que la solidarisation de l'ensemble est assurée par sertissage de la bague métallique externe (13).

**Claims**

1. Device for the electromagnetic screening of electrical cabling consisting of bundles of cables having branched sections, of the type in which each main bundle of cables (1) and each branched bundle of cables (2, 3) are enclosed in a casing consisting of a metal screening braiding, characterized in that each branched section (2, 3) is surrounded by a metal ring (23, 33) covered on the outside by the metal screening casing (21, 31) of the said branched section, and in that the various metal rings (23, 33) of the various branched sections at a point of the cabling are next to one another and the assembly thus formed is covered on the outside successively by the screening casing (11) of the main bundle of cables (1) and by an external metal ring (13) which clamps the assembly.

2. Device for electromagnetic screening according to Claim 1, characterized in that each metal ring (23, 33) which surrounds a branched section is placed around the metal screening casing (21, 31) of the said branched section and is covered on the outside by a turned-back section of the said casing.

3. Device for electromagnetic screening according to one of the preceding claims, characterized in that the metal rings which surround the branched sections have complementary profiles which make up, after they are placed next to one another, an external profile similar to that of the main cable.

4. Device for electromagnetic screening according to one of the preceding claims, characterized in that the assembly is secured by crimping the external metal ring (13).

**Patentansprüche**

1. Anordnung zur elektromagnetischen Abschirmung einer aus Kabelbündeln mit Abzweigungen bestehenden elektrischen Verkabelung, bei der jedes Hauptkabelbündel (1) und jedes Abzweigkabelbündel (2, 3) in einem aus einem metallischen Abschirmgeflecht bestehenden Mantel eingeschlossen sind, dadurch gekennzeichnet, daß jede Abzweigung (2, 3) von einem Metallring (23, 33) umgeben ist, der außen von dem metallischen Abschirmmantel (21, 31) der genannten Abzweigung abgedeckt ist, und daß die einzelnen Metallringe (23, 33) der verschiedenen Abzweigungen in einem Punkt der Verkabelung aneinandergefügt sind und die so gebildete Gesamtheit anschliessend außen von dem Abschirmmantel des Hauptkabelbündels (1) und einem äußeren Metallring (13) abgedeckt wird, der das Zusammenspannen der genannten Gesamtheit ermöglicht.

2. Anordnung zur elektromagnetischen Abschirmung nach Anspruch 1, dadurch gekennzeichnet, daß jeder eine Abzweigung umgebende Metallring (23, 33) um den metallischen Abschirmmantel (21, 31) der betreffenden Abzweigung angeordnet und außen von einem Rücklauf des genannten Abschirmmantels abgedeckt ist.

3. Anordnung zur elektromagnetischen Abschirmung nach einem der vorhergehenden Ansprüche, dadurch gekennzeichnet, daß die die Abzweigungen umgebenden Metallringe, komplementäre Profile haben, die nach dem Aneinanderfügen ein Außenprofil bilden, das dem des Hauptkabelbündels gleicht.

4. Anordnung zur elektromagnetischen Abschirmung nach einem der vorhergehenden Ansprüche, dadurch gekennzeichnet, daß die Festlegung der genannten Gesamtheit durch Quetschen des äußeren Metallrings (13) gesichert ist.

FIG. 1

FIG. 5

0 165 861

FIG. 2

FIG. 3

FIG. 4